# EUROPEAN PATENT APPLICATION

(11) **EP 1 928 110 A2**
(43) Date of publication of application: **04.06.2008**
(21) Application number: 07014096.7
(22) Date of filing: 18.07.2007
(51) Int. Cl.: H04H 20/26

(54) **Method and system for utilizing rate conversion filters to reduce mixing complexity during multipath multi-rate audio processing**

(30) Priority: 30.11.2006 US 565342
(71) Applicant: Broadcom Corporation, Irvine, CA 92617 (US)
(72) Inventor: Kong, Hongwei, Denville, NJ 07834-3462 (US); Zeng, Huaiyu, Red Bank, NJ 07701 (US); Sollenberger, Nelson, Farmingdale, NJ 07727 (US); Chang, Li Fung, Holmdel, NJ 07733 (US)
(74) Representative: Jehle, Volker Armin

(57) **Abstract**

Methods and systems for processing multipath, multi-rate digital audio signals are disclosed herein. Aspects of the method may comprise up-sampling a number of digital audio signals and converting the up-sampled digital audio signals to a common data rate prior to mixing. The digital audio signals sampling rates may be converted utilizing half-band interpolators. The up-sampling may also utilize infinite impulse response interpolators. A portion of the up-sampled digital audio signals may have a common data rate. The common data rate may be determined by the number half-band interpolators utilized. Distortion in the digital audio signals may be compensated utilizing an infinite impulse response filter or a finite impulse response filter.

## Description

### CROSS-REFERENCE TO RELATED APPLICATIONS/INCORPORATION BY REFERENCE

This application makes reference to:
United States Patent Application Serial No. (Attorney Docket No. 18014US01) filed on even date herewith;
United States Patent Application Serial No. (Attorney Docket No. 18016US01) filed on even date herewith;
United States Patent Application Serial No. (Attorney Docket No. 18017US01) filed on even date herewith;
United States Patent Application Serial No. (Attorney Docket No. 18018US01) filed on even date herewith; and
United States Patent Application Serial No. (Attorney Docket No. 18019US01) filed on even date herewith.

Each of the above stated applications is hereby incorporated herein by reference in its entirety.

### FEDERALLY SPONSORED RESEARCH OR DEVELOPMENT

[Not Applicable]

### [MICROFICHE/COPYRIGHT REFERENCE]

[Not Applicable]

### FIELD OF THE INVENTION

Certain embodiments of the invention relate to digital audio processing. More specifically, certain embodiments of the invention relate to a method and system for utilizing rate conversion filters to reduce mixing complexity during multipath, multi-rate audio processing.

### BACKGROUND OF THE INVENTION

In audio applications, systems that provide audio interface and processing capabilities may be required to support duplex operations, which may comprise the ability to collect audio information through a sensor, microphone, or other type of input device while at the same time being able to drive a speaker, earpiece of other type of output device with processed audio signal. In order to carry out these operations, these systems may utilize audio coding and decoding (codec) devices that provide appropriate gain, filtering, and/or analog-to-digital conversion in the uplink direction to circuitry and/or software that provides audio processing and may also provide appropriate gain, filtering, and/or digital-to-analog conversion in the downlink direction to the output devices.

As audio applications expand, such as new voice and/or audio compression techniques and formats, for example, and as they become embedded into wireless systems, such as mobile phones, for example, novel codec devices may be needed that may provide appropriate processing capabilities to handle the wide range of audio signals and audio signal sources. In this regard, added functionalities and/or capabilities may also be needed to provide users with the flexibilities that new communication and multimedia technologies provide. Moreover, these added functionalities and/or capabilities may need to be implemented in an efficient and flexible manner given the complexity in operational requirements, communication technologies, and the wide range of audio signal sources that may be supported by mobile phones. In addition, the more complex design requires more flexible and efficient testing interfaces and capabilities to be included as part of the design, which will allow the designer and the OEM to conduct testing of the product on a scale that has never been done before.

Due to the large number of possible sources of audio signals, the audio processing electronics must be flexible in terms of accepting different data types and sampling rates. The processing requirements for high quality audio such as music may differ drastically from those for voice or other types of audio such as polyphonic ringers. For example, voice signals may be of a lower sampling rate than high quality audio, and as a result, may have more stringent requirements due to the two-way nature of the communication. Voice signals may have very low latency requirements.

Further limitations and disadvantages of conventional and traditional approaches will become apparent to one of skill in the art, through comparison of such systems with the present invention as set forth in the remainder of the present application with reference to the drawings.

### BRIEF SUMMARY OF THE INVENTION

A system and/or method for utilizing rate conversion filters to reduce mixing complexity during multipath, multi-rate audio processing, substantially as shown in and/or described in connection with at least one of the figures, as set forth more completely in the claims.
According to an aspect of the invention, a method is provided for processing audio signals, the method comprising:
receiving a plurality of digital audio signals at a plurality of different data rates; and
up-sampling each of said received plurality of digital audio signals; and
converting said up-sampled received digital audio signals to a common data rate prior to mixing.
Advantageously, the method further comprises converting said plurality of sampling rates in said digital audio signals utilizing half-band interpolators.
Advantageously, said common data rate is determined by a number of said half-band interpolators.
Advantageously, said up-sampling utilizes infinite impulse response interpolators.
Advantageously, a portion of said up-sampled received plurality of digital audio signals has a common data rate.
Advantageously, the method further comprises compensating for distortion in each of said plurality of digital audio signals utilizing infinite impulse response filters.
Advantageously, the method further comprises compensating for distortion in each of said plurality of digital audio signals utilizing finite impulse response filters.
According to an aspect of the invention, a system for processing audio signals is provided, the system comprising:
one or more circuits for receiving a plurality of digital audio signals at a plurality of different data rates; and
said one or more circuits up-sampling each of said received plurality of digital audio signals; and
said one or more circuits converting said up-sampled received digital audio signals to a common data rate prior to mixing.
Advantageously, the system further comprises up-converting said plurality of sampling rates in said digital audio signals utilizing half-band interpolators.
Advantageously, said common data rate is determined by a number of said half-band interpolators.
Advantageously, said up-sampling utilizes infinite impulse response interpolators.
Advantageously, a portion of said up-sampled received plurality of digital audio signals has a common data rate.
Advantageously, compensating for distortion in each of said plurality of digital audio signals utilizes infinite impulse response filters.
Advantageously, compensating for distortion in each of said plurality of digital audio signals utilizes finite impulse response filters.
According to an aspect of the invention, a machine-readable storage is provided having stored thereon, a computer program having at least one code section for processing audio signals, the at least one code section being executable by a machine for causing the machine to perform steps comprising:
receiving a plurality of digital audio signals at a plurality of different data rates; and
up-sampling each of said received plurality of digital audio signals; and
converting said up-sampled received digital audio signals to a common data rate prior to mixing.
Advantageously, said at least one code section comprises code for up-converting said plurality of sampling rates in said digital audio signals utilizing half-band interpolators.
Advantageously, said at least one code section comprises code for determining said common data rate by a number of said half-band interpolators.
Advantageously, said at least one code section comprises code for up-sampling said each of said received plurality of digital audio signals utilizing infinite impulse response interpolators.
Advantageously, said at least one code section comprises code for setting a portion of said up-sampled received plurality of digital audio signals at a common data rate.
Advantageously, said at least one code section comprises code for compensating for distortion in each of said plurality of digital audio signals utilizing infinite impulse response filters.
Advantageously, said at least one code section comprises code for compensating for distortion in each of said plurality of digital audio signals utilizing finite impulse response filters.

Various advantages, aspects and novel features of the present invention, as well as details of an illustrated embodiment thereof, will be more fully understood from the following description and drawings.

### BRIEF DESCRIPTION OF SEVERAL VIEWS OF THE DRAWINGS

FIG. 1 is a block diagram that illustrates an exemplary multimedia baseband processor that enables handling of a plurality of wireless protocols, in accordance with an embodiment of the invention.

FIG. 2A is a block diagram illustrating an exemplary multimedia baseband processor communicatively coupled to a Bluetooth radio, in accordance with an embodiment of the invention

FIG. 2B is a block diagram illustrating an exemplary audio codec in a multimedia baseband processor, in accordance with an embodiment of the invention.

FIG. 2C is a block diagram illustrating an exemplary analog processing unit in a multimedia baseband processor, in accordance with an embodiment of the invention.

FIG. 2D is a flow diagram illustrating exemplary steps for data mixing in the audio codec, in accordance with an embodiment of the invention.

FIG. 3 is a block diagram illustrating an exemplary digital audio compensation and data rate interpolator, in accordance with an embodiment of the invention.

FIG. 4 is a block diagram of an exemplary infinite impulse response compensation filter in the form of cascaded biquads, in accordance with an embodiment of the invention.

FIG. 5 is a block diagram illustrating an exemplary finite impulse response (FIR) filter in the direct form, in accordance with an embodiment of the invention.

FIG. 6 is a block diagram illustrating an exemplary half-band interpolation filter (HBIF), in accordance with an embodiment of the invention.

FIG. 7 is a block diagram illustrating an exemplary cascaded biquad infinite impulse response (IIR) interpolation filter, in accordance with an embodiment of the invention.

FIGS. 8-11 are block diagrams illustrating exemplary half-band interpolation filters, in accordance with an embodiment of the invention.

FIG. 12 is a flow diagram illustrating exemplary steps for audio signal compensation and sampling rate interpolation, in accordance with an embodiment of the invention.

### DETAILED DESCRIPTION OF THE INVENTION

Certain aspects of the invention may be found in a method and system for utilizing rate conversion filters to reduce mixing complexity during multipath, multi-rate audio processing. In this regard, a multipath may refer to the use of multiple processing paths that may be enabled for processing audio signals received from a plurality of sources. Moreover, a multi-rate may refer to enabling the reception of audio signals in a plurality of sampling rates and converting them to different sampling rates in accordance with the processing requirements. Aspects of the method may comprise up-sampling a number of digital audio signals and converting the up-sampled digital audio signals to a common data rate prior to mixing. The digital audio signals sampling rates may be converted utilizing half-band interpolators. The up-sampling may also utilize infinite impulse response interpolators. A portion of the up-sampled digital audio signals may have a common data rate. The common data rate may be determined by the number of half-band interpolators utilized to generate the up-sampled digital audio signals. Distortion in the digital audio signals may be compensated for utilizing a number of cascaded biquad filters or a finite impulse response filter.

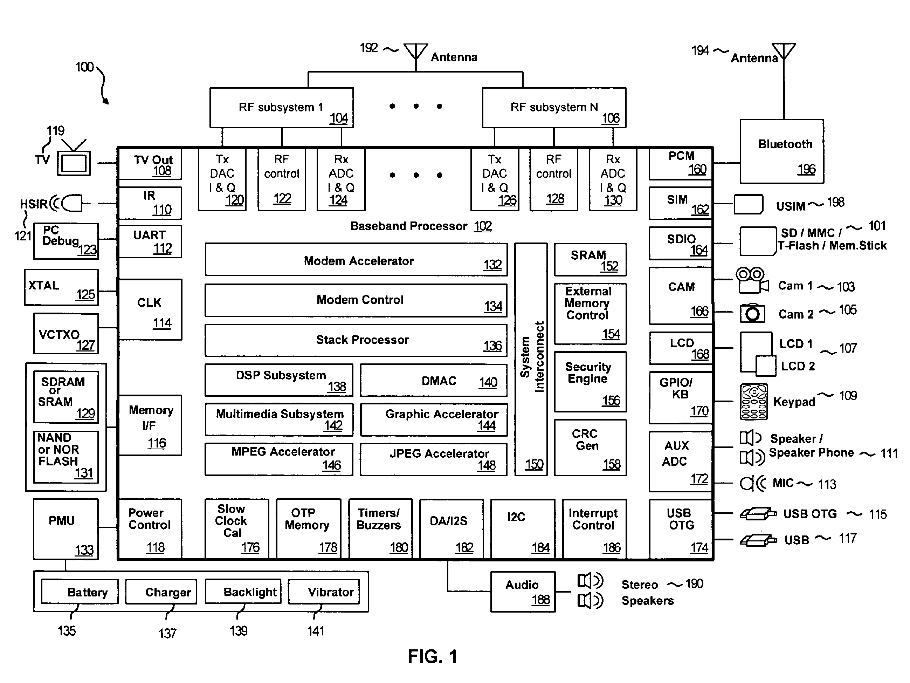

FIG. 1 is a block diagram that illustrates an exemplary multimedia baseband processor that enables handling of a plurality of wireless protocols, in accordance with an embodiment of the invention. Referring to FIG. 1, there is shown a wireless system 100 that may correspond to a wireless handheld device, for example. In this regard, United States Application Serial No. 11/354,704, filed February 14, 2006, discloses a method and system for a processor that handles a plurality of wireless access communication protocols, and is hereby incorporated herein by reference in its entirety. The wireless system 100 may comprise a baseband processor 102 and a plurality of RF subsystems 104, ..., 106. In this regard, an RF subsystem may correspond to a WCDMA/HSDPA RF subsystem or to a GSM/GPRS/EDGE RF subsystem, for example. The wireless system 100 may also comprise a Bluetooth radio 196, a plurality of antennas 192 and 194, a TV 119, a high-speed infra-red (HSIR) 121, a PC debug block 123, a plurality of crystal oscillators 125 and 127, a SDRAM block 129, a NAND block 131, a power management unit (PMU) 133, a battery 135, a charger 137, a backlight 139, and a vibrator 141. The Bluetooth radio 196 may be coupled to an antenna 194. The Bluetooth radio 196 may be integrated within a single chip. The wireless system 100 may further comprise an audio block 188, one or more such as speakers 190, one or more USB devices such as USB devices 117 and 119, a microphone (MIC) 113, a speaker phone 111, a keypad 109, one or more displays such as LCD's 107, one or more cameras such as cameras 103 and 105, a removable memory such as memory stick 101, and a UMTS subscriber identification module (USIM) 198.

The baseband processor 102 may comprise a TV out block 108, an infrared (IR) block 110, a universal asynchronous receiver/transmitter (UART) 112, a clock (CLK) 114, a memory interface 116, a power control block 118, a slow clock block 176, a OTP memory block 178, timers block 180, an inter-integrated circuit sound (12S) interface block 182, an inter-integrated circuit (12C) interface block 184, an interrupt control block 186. The baseband processor 102 may further comprise a USB on-the-go (OTG) block 174, a AUX ADC block 172, a general-purpose I/O (GPIO) block 170, a LCD block 168, a camera block 166, a SDIO block 164, a SIM interface 162, and a pulse code modulation (PCM) block 160. The baseband processor 102 may communicate with the Bluetooth radio 196 via the PCM block 160, and in some instances, via the UART 112 and/or the 12S block 182, for example.

The baseband processor 102 may further comprise a plurality of transmit (Tx) digital-to-analog converter (DAC) for in-phase (I) and quadrature (Q) signal components 120, ..., 126, plurality of RF control 122, ..., 128, and a plurality of receive (Rx) analog-to-digital converter (ADC) for I and Q signal components 124, ..., 130. In this regard, receive, control, and/or transmit operations may be based on the type of transmission technology, such as EDGE, HSDPA, and/or WCDMA, for example. The baseband processor 602 may also comprise an SRAM block 152, an external memory control block 154, a security engine block 156, a CRC generator block 158, a system interconnect 150, a modem accelerator 132, a modem control block 134, a stack processor block 136, a DSP subsystem 138, a DMAC block 140, a multimedia subsystem 142, a graphic accelerator 144, an MPEG accelerator 146, and a JPEG accelerator 148. Notwithstanding the wireless system 100 disclosed in FIG. 1, aspects of the invention need not be so limited.

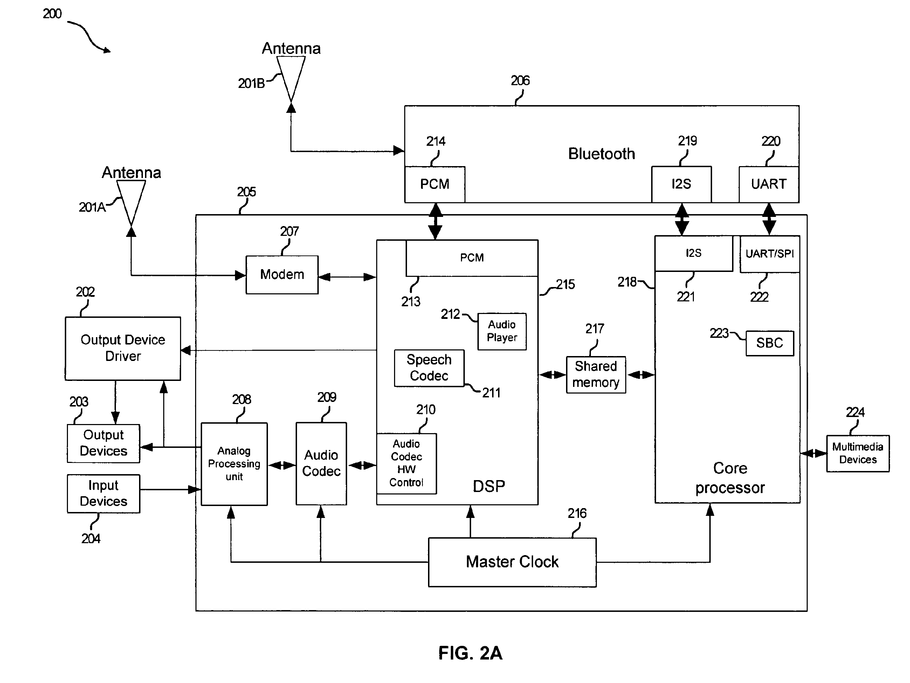

FIG. 2A is a block diagram illustrating an exemplary multimedia baseband processor communicatively coupled to a Bluetooth radio, in accordance with an embodiment of the invention. Referring to FIG. 2A, there is shown a wireless system 200 that may comprise a baseband processor 205, antennas 201a and 201b, a Bluetooth radio 206, an output device driver 202, output devices 203, input devices 204, and multimedia devices 224. The wireless system 200 may comprise similar components as those disclosed for the wireless system 100 in FIG. 1. The baseband processor 205 may comprise a modem 207, a digital signal processor (DSP) 215, a shared memory 217, a core processor 218, a speech coder/decoder unit (codec) 209, an analog processing unit 208, and a master clock 216. The core processor 218 may be, for example, an ARM processor integrated within the baseband processor 205. The DSP 215 may comprise a speech codec 211, an audio player 212, a PCM block 213, and an audio codec hardware control 210. The core processor 218 may comprise an 12S block 221, a UART and serial peripheral interface (UART/SPI) block 222, and a sub-band coding (SBC) codec 223. The Bluetooth radio 206 may comprise a PCM block 214, an 12S block 219, and a UART 220.

The antennas 201 a and 210b may comprise suitable logic circuitry, and/or code that may enable wireless signals transmission and/or reception. The output device driver 202 may comprise suitable logic, circuitry, and/or code that may enable controlling the operation of the output devices 203. In this regard, the output device driver 202 may receive at least one signal from the DSP 215 and/or may utilize at least one signal generated by the analog processing unit 208. The output devices 203 may comprise suitable logic, circuitry, and/or code that may enable playing, storing, and/or communicating analog audio, voice, polyringer, and/or mixed signals from the analog processing unit 208. The output devices 203 may comprise speakers, speaker phones, stereo speakers, headphones, and/or storage devices such as audio tapes, for example. The input devices 204 may comprise suitable logic, circuitry, and/or code that may enable receiving of analog audio and/or voice data and communicating it to the analog processing unit 208 for processing. The input devices 204 may comprise one or more microphones and/or auxiliary microphones, for example. The multimedia devices 224 may comprise suitable logic, circuitry, and/or code that may be enable communication of multimedia data with the core processor 218 in the baseband processor 205. The multimedia devices 224 may comprise cameras, video recorders, video displays, and/or storage devices such as memory sticks, for example.

The Bluetooth radio 206 may comprise suitable logic, circuitry, and/or code that may enable transmission, reception, and/or processing of information by utilizing the Bluetooth radio protocol. In this regard, the Bluetooth radio 206 may support amplification, filtering, modulation, and/or demodulation operations, for example. The Bluetooth radio 206 may enable data to be transferred from and/or to the baseband processor 205 via the PCM block 214, the 12S block 219, and/or the UART 220, for example. In this regard, the Bluetooth radio 206 may communicate with the DSP 215 via the PCM block 214 and with the core processor 218 via the 12S block 221 and the UART/SPI block 222.

The modem 207 in the baseband processor 205 may comprise suitable logic, circuitry, and/or code that may enable modulation and/or demodulation of signals communicated via the antenna 201a. The modem 207 may communicate with the DSP 205. The shared memory 217 may comprise suitable logic, circuitry, and/or code that may enable storage of data. The shared memory 217 may be utilized for communicating data between the DSP 215 and the core processor 218. The master clock 216 may comprise suitable logic, circuitry, and/or code that may enable generating at least one clock signal for various components of the baseband processor 205. For example, the master clock 216 may generate at least one clock signal that may be utilized by the analog processing unit 208, the audio codec 209, the DSP 215, and/or the core processor 218, for example.

The core processor 218 may comprise suitable logic, circuitry, and/or code that may enable processing of audio and/or voice data communicated with the DSP 215 via the shared memory 217. The core processor 218 may comprise suitable logic, circuitry, and/or code that may enable processing of multimedia information communicated with the multimedia devices 224. In this regard, the core processor 218 may also control at least a portion of the operations of the multimedia devices 224, such as generation of signals for controlling data transfer, for example. The core processor 218 may also enable communicating with the Bluetooth radio via the 12S block 221 and/or the UART/SPI block 222. The core processor 218 may also be utilized to control at least a portion of the operations of the baseband processor 205, for example. The SBC codec 223 in the core processor may comprise suitable logic, circuitry, and/or code that may enable coding and/or decoding audio signals, such as music or mixed audio data, for example, for communication with the Bluetooth radio 206.

The DSP 215 may comprise suitable logic, circuitry, and/or code that may enable processing of a plurality of audio signals, such as digital general audio data, digital voice data, and/or digital polyringer data, for example. In this regard, the DSP 215 may enable generation of digital polyringer data. The DSP 215 may also enable generation of at least one signal that may be utilized for controlling the operations of, for example, the output device driver 202 and/or the audio codec 209. The DSP 215 may be utilized to communicate processed audio and/or voice data to the core processor 218 and/or to the Bluetooth radio 206. The DSP 215 may also enable receiving audio and/or voice data from the Bluetooth radio 206 and/or from the multimedia devices 224 via the core processor 218 and the shared memory 217.

The speech codec 211 may comprise suitable logic, circuitry, and/or code that may enable coding and/or decoding of voice data. The audio player 212 may comprise suitable logic, circuitry, and/or code that may enable coding and/or decoding of audio or musical data. For example, the audio player 212 may be utilized to process digital audio encoding formats such as MP3, WAV, AAC, uLAW/AU, AIFF, AMR, and MIDI, for example. The audio codec hardware control 210 may comprise suitable logic, circuitry, and/or code that may enable communication with the audio codec 209. In this regard, the DSP 215 may communicate more than one audio signal to the audio codec 209 for processing. Moreover, the DSP 215 may also communicate more than one signal for controlling the operations of the audio codec 209.

The audio codec 209 may comprise suitable logic, circuitry, and/or code that may enable processing audio signals received from the DSP 215 and/or from input devices 204 via the analog processing unit 208. The audio codec 209 may enable utilizing a plurality of digital audio inputs, such as 16 or 18-bit inputs, for example. The audio codec 209 may also enable utilizing a plurality of data sampling rate inputs. For example, the audio codec 209 may accept digital audio signals at sampling rates such as 8 kHz, 11.025 kHz, 12 kHz, 16 kHz, 22.05 kHz, 24 kHz, 32 kHz, 44.1 kHz, and/or 48 kHz. The audio codec 209 may also support mixing of a plurality of audio sources. For example, the audio codec 209 may support at least three audio sources, such as general audio, polyphonic ringer, and voice. In this regard, the general audio and polyphonic ringer sources may support the plurality of sampling rates that the audio codec 209 is enabled to accept, while the voice source may support a portion of the plurality of sampling rates, such as 8 kHz and 16 kHz, for example.

The audio codec 209 may also support independent and dynamic digital volume or gain control for each of the audio sources that may be supported. The audio codec 209 may also support a mute operation that may be applied to each of the audio sources independently. The audio codec 209 may also support adjustable and programmable soft ramp-ups and ramp-down for volume control to reduce the effects of clicks and/or other noises, for example. The audio codec 209 may also enable downloading and/or programming a multi-band equalizer to be utilized in at least a portion of the audio sources. For example, a 5-band equalizer may be utilized for audio signals received from general audio and/or polyphonic ringer sources.

The audio codec 209 may also utilize a programmable infinite impulse response (IIR) filter and/or a programmable finite impulse response (FIR) filter for at least a portion of the audio sources to compensate for passband amplitude and phase fluctuation for different output devices. In this regard, filters coefficients may be configured or programmed dynamically based on current operations. Moreover, filter coefficients may all be switched in one-shot or may be switched sequentially, for example. The audio codec 209 may also utilize a modulator, such as a Delta-Sigma (Δ-Σ) modulator, for example, to code digital output signals for analog processing.

The audio codec 209 may also utilize infinite impulse response (IIR) and half-band interpolator filters to up-convert the data rates of incoming signals. A number of filters may be utilized to step-up the sampling rates to a common rate. As with the compensation filter, the frequency response of the interpolator filters may be adjusted by setting gain coefficients.

In operation, the audio codec 209 in the wireless system 200 may communicate with the DSP 215 in order to transfer audio data and control signals. Control registers for the audio codec 209 may reside within the DSP 215. For voice data, the audio samples need not be buffered between the DSP 215 and the audio codec 209. For general audio data and for polyphonic ringer path, audio samples from the DSP 215 may be written into a FIFO and then the audio codec 209 may fetch the data samples. The DSP 215 and the core processor 218 may exchange audio signals and control information via the shared memory 217. The core processor 218 may write PCM audio directly into the shared memory 217. The core processor 218 may also communicate coded audio data to the DSP 215 for computationally intensive processing. In this regard, the DSP 215 may decode the data and may writes the PCM audio signals back into the shared memory 217 for the core processor 218 to access. Moreover, the DSP 215 may decode the data and may communicate the decoded data to the audio codec 209. The core processor 218 may communicate with the audio codec 209 via the DSP 215. Notwithstanding the wireless system 200 disclosed in FIG. 2A, aspects of the invention need not be so limited.

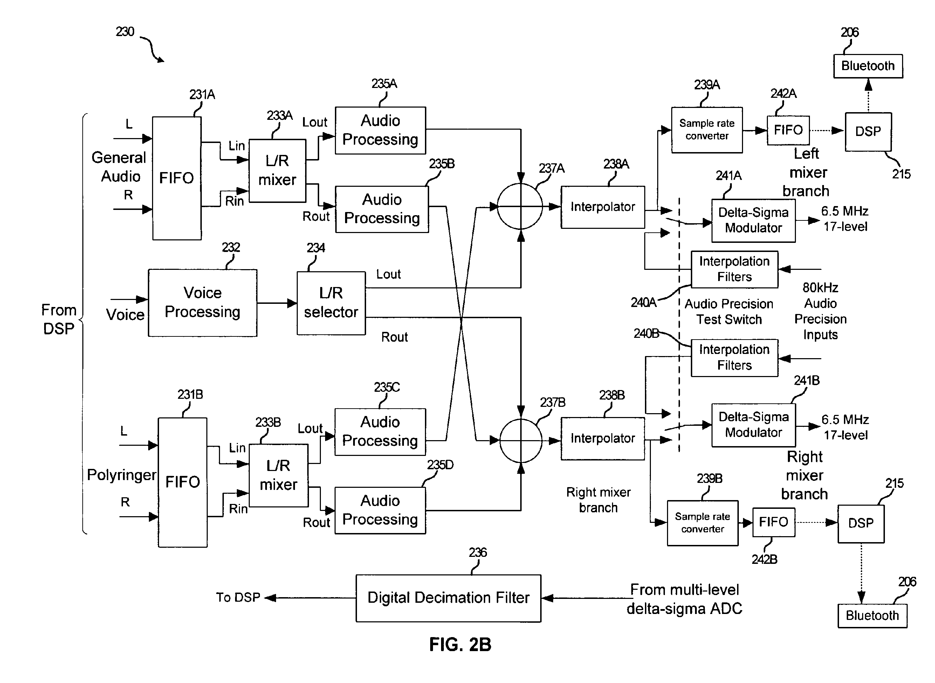

FIG. 2B is a block diagram illustrating an exemplary audio codec in a multimedia baseband processor, in accordance with an embodiment of the invention. Referring to FIG. 2B, there is shown an audio codec 230 that may correspond to the audio codec 209 disclosed in FIG. 2A. The audio codec 230 may comprise a first portion for communicating data from a DSP, such as the DSP 215, to output devices and/or to a Bluetooth radio, such the output devices 203 and the Bluetooth radio 206. The audio codec 230 may also comprise a second portion that may be utilized for communicating data from input devices, such as the input devices 204, to the DSP 215, for example.

The first portion of the audio codec 230 may comprise a general audio path from the DSP 215, a voice path from the DSP 215, and a polyphonic ringer or polyringer path from the DSP 215. In this regard, the audio codec 230 may utilize a separate processing path before mixing each audio source or audio source type that may be supported. The general audio path may comprise a FIFO 231A, a left and right channels (L/R) mixer 233A, a left channel audio processing block 235A, and a right channel audio processing block 235B. The voice path may comprise a voice processing block 232 and a left and right channels (L/R) selector 234. The polyringer path may comprise a FIFO 231 B, an L/R mixer 233B, a left channel audio processing block 235C, and a right channel audio processing block 235D.

Regarding the general audio path and the polyringer path, the FIFOs 231A and 231 B may comprise suitable logic, circuitry, and/or code that may enable storage of left and right channels audio signals from general audio source and polyringer source respectively. In this regard, each of the audio signals may be sampled at one of a plurality of sample rates that may be supported by the audio codec 230 for general audio data and/or polyringer data. The L/R mixer 233A may comprise suitable logic, circuitry, and/or code that may enable mixing the input right and left channels from the FIFO 231A to generate mixed left and right channels outputs to the audio processing blocks 235A and 235B respectively. The L/R mixer 233B may comprise suitable logic, circuitry, and/or code that may enable mixing the input right and left channels from the FIFO 231 B to generate mixed left and right channels outputs to the audio processing blocks 235C and 235D respectively. The audio processing blocks 235A, 235B, 235C, and 235D may comprise suitable logic, circuitry, and/or code that may enable processing audio signals. In this regard, the audio processing blocks 235A, 235B, 235C, and/or 235D may support equalization operations, compensation operations, rate adaptation operations, and/or volume control operations, for example. The outputs of the audio processing blocks 235A and 235C may be communicated to the left channel branch mixer 237A. The outputs of the audio processing blocks 235B and 235D may be communicated to the right channel branch mixer 237B. The rate adaptation operations enable the outputs of the audio processing blocks 235A, 235B, 235C, and 235D to be at the same sampling rate when communicated to the mixers 237A and 237B.

Regarding the voice path, the voice processing block 232 may comprise suitable logic, circuitry, and/or code that may enable processing voice received from the DSP 215 in one of a plurality of voice sampling rates supported by the audio codec 230. In this regard, the voice processing block 232 may support compensation operations, rate adaptation operations, and/or volume control operations, for example. The L/R selector 234 may comprise suitable logic, circuitry, and/or code that may enable separating the voice signal contents into a right channel signal that may be communicated to the mixer 237B and a left channel signal that may be communicated to the mixer 237A. The rate adaptation operation may enable the outputs of the voice processing blocks 232 to be at the same sampling rate as the outputs of the audio processing blocks 235A, 235B, 235C, and/or 235D when communicated to the mixers 237A and 237B. For example, the input signals to the mixers 237A and 237B may be adjusted via up and/or down sampling in the audio processing blocks 235A, 235B, 235C, and 235D and the voice processing block 232 to have the same sampling rates.

The mixer 237A may comprise suitable logic, circuitry, and/or code that may enable mixing the outputs of the audio processing blocks 235A and 235C and the left channel output of the L/R selector 234. The mixer 237B may comprise suitable logic, circuitry, and/or code that may enable mixing the outputs of the audio processing blocks 235B and 235D and the right channel output of the L/R selector 234. The output of the mixer 237A may be associated with the left channel branch of the audio codec 230 while the output of the mixer 237B may be associated with the right channel branch of the audio codec 230. Also associated with the left channel branch may be an interpolator 238A, a sample rate converter 239A, a FIFO 242A, a Δ-Σ modulator 241A, and an interpolation filter 240A. Also associated with the right channel branch may be an interpolator 238B, a sample rate converter 239B, a FIFO 242B, a Δ-Σ modulator 241 B, and an interpolation filter 240B. The interpolation filters 240A and 240B may be optional and may be utilized for testing, for example, to interface to audio testing equipment using the Audio Precision interface or any other interfaces adopted in the industry.

The interpolators 238A and 238B may comprise suitable logic, circuitry, and/or code that may enable up-sampling of the outputs of the mixers 237A and 237B. The sample rate converters 239A and 239B may comprise suitable logic, circuitry, and/or code that may enable adjusting the output signals from the interpolators 238A and 239B to a sampling rate that may be utilized by the DSP 215 and/or the core processor 218 for communication to the Bluetooth radio 206. In this regard, the sample rate converters 239A and 239B may adjust the sampling rates to 44.1 kHz or 48 kHz, for example, for subsequent communication to the Bluetooth radio 206. The sample rate converters 239A and 239B may be implemented as interpolators, such as linear interpolators or more sophisticated decimation filters, for example. The audio and/or voice signal outputs from the sample rate converters 239A and 239B may be communicated to FIFOs 242A and 242B before being communicated to the DSP 215 and/or core processor 218 and later to the Bluetooth radio 206. The Δ-Σ modulators 241A and 241 B may comprise suitable logic, circuitry, and/or code that may enable further bitwidth reduction of the outputs of the interpolators 238A and 238B to achieve a specified level output signal. For example, the Δ-Σ modulators 241A and 241B may receive 23-bit 6.5 MHz signals from the interpolators 238A and 238B and may reduce the signal levels to generate 6.5 MHz 17-level signals, for example.

The second portion of the audio codec 230 may comprise a digital decimation filter 236. The digital decimation filter 236 may comprise suitable logic, circuitry, and/or code that may enable processing a digital audio signal received from the analog processing unit 208, for example, before communicating the processed audio signal to the DSP 215. The digital decimation filter 236 may comprise FIR decimation filters or CIC decimation filters that may be followed by a plurality of IIR compensation and decimation filters, for example.

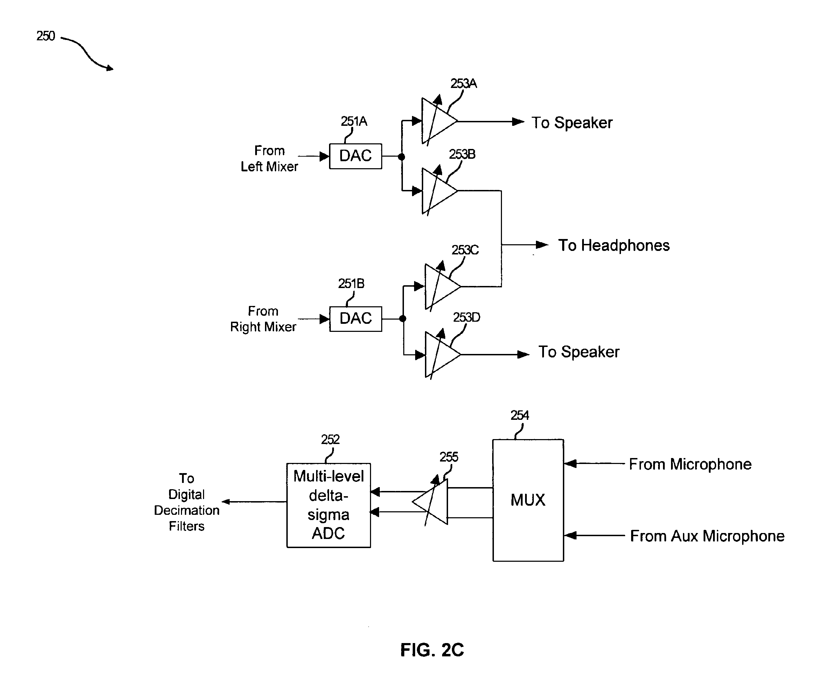

FIG. 2C is a block diagram illustrating an exemplary analog processing unit in a multimedia baseband processor, in accordance with an embodiment of the invention. Referring to FIG. 2C, there is shown an analog processing unit 250 that may correspond to the analog processing unit 208 in FIG. 2A. The analog processing unit 250 may comprise a first portion for digital-to-analog conversion and a second portion for analog-to-digital conversion. The first portion may comprise a first digital-to-analog converter (DAC) 251A and a second DAC 251B that may each comprise suitable logic, circuitry, and/or code that may enable converting digital signals from the left and the right mixer branches in the audio codec 230, respectively, to analog signals. The output of the DAC 251A may be communicated to the variable gain amplifiers 253A and 253B. The output of the DAC 251 B may be communicated to the variable gain amplifiers 253C and 253D. The variable gain amplifiers 253A, 253B, 253C, and 253D may each comprise suitable logic, circuitry, and/or code that may enable dynamic variation of the gain applied to their corresponding input signals. The output of the amplifier 253A may be communicated to at least one left speaker while the output of the amplifier 253D may be communicated to at least one right speaker, for example. The outputs of amplifiers 253B and 253D may be combined and communicated to a set of headphones, for example.

The second portion of the analog processing unit 250 may comprise a multiplexer (MUX) 254, a variable gain amplifier 255, and a multi-level Delta-Sigma (Δ-Σ) analog-to-digital converter (ADC) 252. The MUX 254 may comprise suitable logic, circuitry, and/or code that may enable selection of an input analog signal from a microphone or from an auxiliary microphone, for example. The variable gain amplifier 255 may comprise suitable logic, circuitry, and/or code that may enable dynamic variation of the gain applied to the analog output of the MUX 254. The multi-level Δ-Σ ADC 252 may comprise suitable logic, circuitry, and/or code that may enable conversion of the amplified output of the variable gain amplifier 255 to a digital signal that may be communicated to the digital decimation filter 236 in the audio codec 230 disclosed in FIG. 2B. In some instances, the multi-level Δ-Σ ADC 252 may be implemented as a 3-level Δ-Σ ADC, for example. Notwithstanding the exemplary analog processing unit 250 disclosed in FIG. 2C, aspects of the invention need not be so limited.

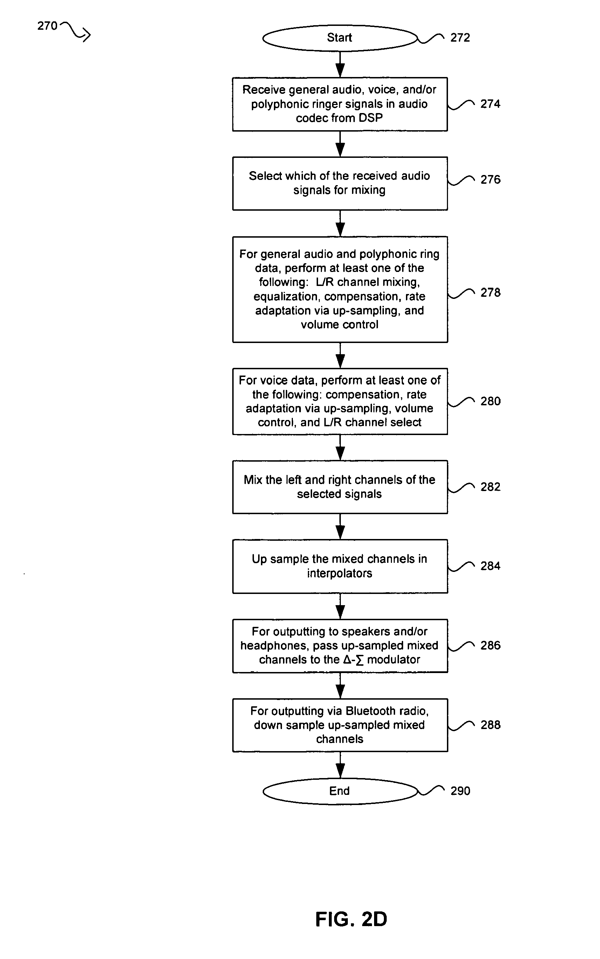

FIG. 2D is a flow diagram illustrating exemplary steps for data mixing in the audio codec, in accordance with an embodiment of the invention. Referring to FIG. 2D, there is shown a flow 270. After start step 272, in step 274, the audio codec 230 disclosed in FIG. 2B may receive two or more audio signals from a general audio source, a polyphonic ringer audio source, and/or a voice audio source via the DSP 215, for example. In step 276, the audio codec 230 may be utilized to select two or more of the received audio signals for mixing. In this regard, portions of the audio codec 230 may be programmed, adjusted, and/or controlled to enable selected audio signals to be mixed. For example, a mute operation may be utilized to determine which audio signals may be mixed in the audio codec 230.

In step 278, when the audio signals to be mixed comprises general audio and/or polyphonic ringer audio, the signals may be processed in the audio processing blocks 235A, 235B, 235C, and 235D where equalization operations, compensation operations, rate adaptation operations, and/or volume control operations may be performed on the signals. Regarding the rate adaptation operations, the data sampling rate of the input general audio or polyphonic ringer audio signals may be adapted to a specified sampling rate for mixing. In step 280, when one of the audio signals to be mixed comprises voice, the voice signal may be processed in the voice processing block 232 where compensation operations, rate adaptation operations, and/or volume control operations may be performed on the voice signals. Regarding the rate adaptation operations, the data sampling rate of the input voice signals may be adapted to specified sampling rate for mixing.

In step 282, the left channel general audio and polyringer signals generated by the audio processing blocks 235A and 235C and the left channel voice signals generated by the L/R selector 234 may be mixed in the mixer 237A. Similarly, the right channel general audio and polyringer signals generated by the audio processing blocks 235B and 235D and the right channel voice signals generated by the L/R selector 234 may be mixed in the mixer 237B. In step 284, the outputs of the mixers 237A and 237B corresponding to the mixed left and right channel signals may be up-sampled by the interpolators 238A and 238B respectively. By generating signals with a higher sampling rate after mixing, the implementation of the sample rate converters 239A and 239B may also be simplified.

In step 286, when communicating the up-sampled mixed left and right channels signals to output devices, such as the output devices 203 disclosed in FIG. 2A, the audio codec 230 may utilize the Δ-Σ modulators 241A and 241B to reduce the digital audio signals to signals with much fewer but appropriate levels. In this regard, the output signals may be communicated to the DACs 251A and 251 B and to the variable gain amplifiers 253A, 253B, 253C, and 253D disclosed in FIG. 2C for analog conversion and for signal gain respectively. In step 288, when communicating the up-sampled mixed left and right channel signals to the Bluetooth radio 206, the audio codec 230 may down-sample the audio signals by utilizing the sample rate converters 239A and 239B and then communicating the down-sampled signals to the FIFOs 242A and 242B. The DSP 215 may fetch the down-sampled audio signals from the FIFOs 242A and 242B and may then communicate the digital audio signals to the Bluetooth radio 206. Notwithstanding the exemplary steps for mixing audio sources disclosed in FIG. 2D, aspects of the invention need not be so limited.

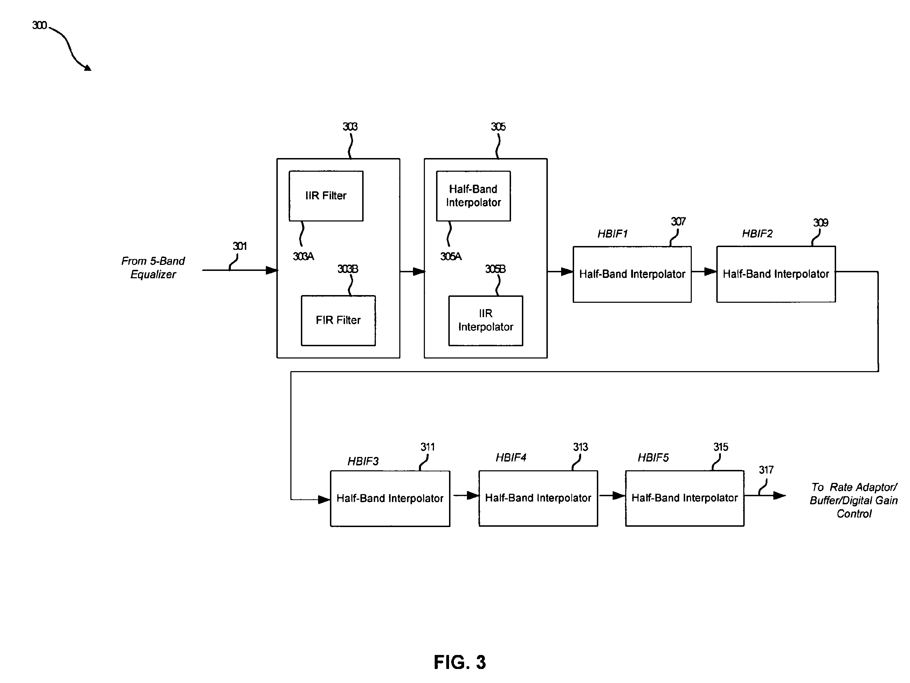

FIG. 3 is a block diagram of an exemplary digital audio compensation and data rate interpolator, in accordance with an embodiment of the invention. Referring to FIG. 3, there is shown a digital audio compensation and data rate interpolator 300 which may comprise a compensation filter 303 and interpolator blocks 305, 307, 309, 311, 313 and 315. The compensation filter 303 may comprise an infinite impulse response (IIR) filter 303A, which may be a cascaded biquad filter for example, and a finite impulse response (FIR) filter 303B. The interpolator block 305 may comprise a half-band interpolator filter (HBIF) 305A and an infinite impulse response interpolator 305B. An FIR and a half-band interpolator may be implemented in the direct-form or in the transpose form. An IIR filter and an IIR interpolator may be implemented in the direct form I, II, transpose-form, cascaded second-order sections (biquads) or parallel form. The interpolator blocks 307, 309, 311, 313 and 315 may comprise half-band interpolators HBIF1, HBIF2, HBIF3, HBIF4 and HBIF5, respectively. The digital audio input signal 301 may be communicated to the compensation filter 303. The output of the compensation filter 303 may be communicated to the interpolator block 305 which may then be communicated to the HBIF 307. The output of the HBIF1 307 may be communicated to the HBIF2 309, then similarly with the HBIF3 311, the HBIF4, 313, and the HBIF5 315. The output of HBIF5 may be communicated from the digital audio compensation and data rate interpolator 300 to subsequent circuits such as a rate adaptor, a buffer, and/or digital gain circuit, for example.

The compensation filter 303 may comprise suitable logic, circuitry, and/or code for compensation of distortion that may have been introduced by output devices such as speakers and/or ear buds, for example. In one embodiment of the invention, a cascaded biquad filter 303A or a FIR filter 303B may be utilized for distortion compensation. In this regard, the cascaded biquad filter 303A or the FIR filter 303B may be selected for compensation of distortion in the digital audio input signal 301. In instances where the cascaded biquad filter 303A may be activated, signals may be routed to its inputs, and conversely, in instances when the FIR filter 303B may be activated, input signals may be routed to its inputs. The cascaded biquad filter 303A may be utilized with voice signals, for example. The FIR filter 303B may be utilized for the compensation of distortion in high quality audio in the digital audio input signal 301.

The interpolator blocks 305 307, 309, 311, 313, and 315 may comprise suitable logic, circuitry and/or code for up-converting the sample rate of the incoming digital audio signal by two in each stage. Table 1 below illustrates exemplary sampling rates in kHz at each stage of a five-stage interpolator from the input audio signal into the interpolator block 305 and then through each interpolator up to HBIF5 315, in accordance with an embodiment of the invention.

**Table 1**

| Input (kHz) | IIR/HBIF0 | HBIF1 | HBIF2 | HBIF3 | HBIF4 | HBIF5 |
|---|---|---|---|---|---|---|
| 8 | 16 | 32 | 64 | 128 | 256 | 512 |
| 12 | 24 | 48 | 96 | 192 | 384 | 768 |
| 16 | 32 | 64 | 128 | 256 | 512 | 512 |
| 24 | 48 | 96 | 192 | 384 | 768 | 768 |
| 32 | 64 | 128 | 256 | 512 | 512 | 512 |
| 48 | 96 | 192 | 384 | 768 | 768 | 768 |
| 11.025 | 22.05 | 44.1 | 88.2 | 176.4 | 352.8 | 705.6 |
| 22.05 | 44.1 | 88.2 | 176.4 | 352.8 | 705.6 | 705.6 |
| 44.1 | 88.2 | 176.4 | 352.8 | 705.6 | 705.6 | 705.6 |

As shown in the example illustrated by Table 1, the sampling rates supported for the digital audio input signal may be doubled at each stage up to certain sampling rates, thus reducing the number of sampling rates from nine to three. In instances where the sampling rate reaches a final value at a stage earlier than HBIF5, such as 512, 705.6, or 768 kHz at HBIF3 or at HBIF 4 in the example illustrated in Table 1, the HBIF stages subsequent to that stage may not be activated and the output of that stage may be directly routed to the output 317. The number of sampling rates may be further reduced utilizing a rate adaptor, for example. United States Application Serial No. (Attorney Docket No. 180113US01) filed on even date herewith, discloses an exemplary rate adaptor and is hereby incorporated by reference. Notwithstanding the exemplary compensation filter 303 and data rate interpolator blocks 305, 307, 309, 311, 313 and 315 disclosed in FIG. 3, aspects of the invention need not be so limited.

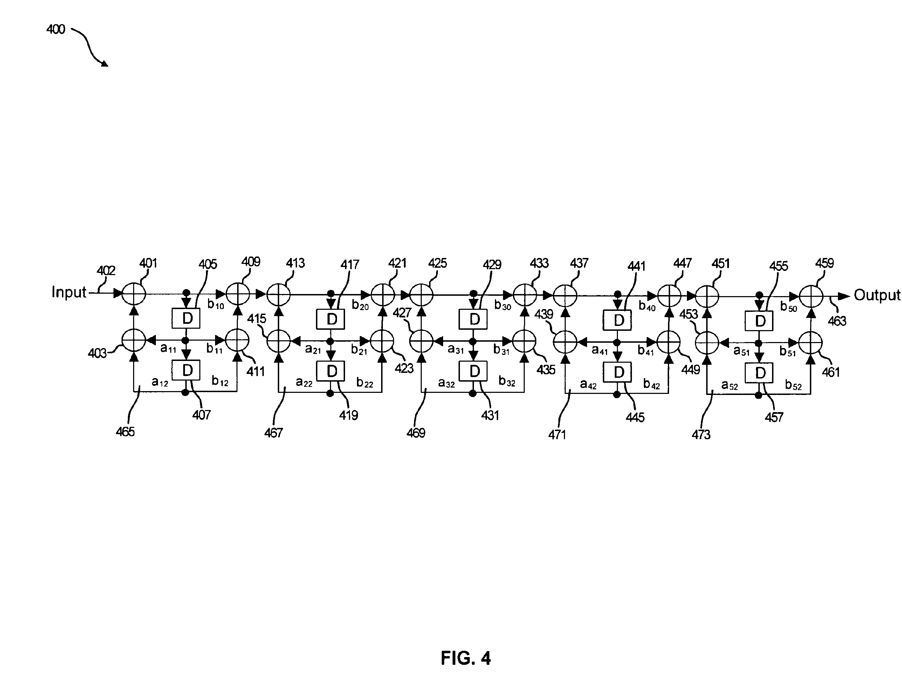

FIG. 4 is a block diagram of an exemplary infinite impulse response compensation filter in the form of cascaded biquads, in accordance with an embodiment of the invention. Referring to FIG. 4, there is shown cascaded biquad compensation filter 400, which comprises adders 401, 403, 409, 411, 413, 415, 421, 423, 425, 427, 433, 435, 437, 439, 447, 449, 451, 453, 459 and 461 and delay cells 405, 407, 417, 419, 429, 431, 441, 445, 455, and 457. In one embodiment of the invention, the cascaded biquad 400 may comprise five biquad stages 465, 467, 469, 471 and 473. In the first biquad stage 407, which may comprise adders 401, 403, 409 and 411 and delay cells 405 and 407, the input signal 402 may be communicated to the input of adder 401. The output of the adder 403 may be communicated to another input of the adder 401. The output of the adder 401 may be communicated to delay cell 405 and may also multiplied by coefficient b₁₀ before being communicated to the adder 409. The output of the delay cell 405 may be communicated to the delay cell 407, and may also be multiplied by coefficient a₁₁ before being communicated to the adder 403, and may be multiplied by coefficient b₁₁ before being communicated to the adder 411. The output of the delay cell 407 may be multiplied by coefficient a₁₂ and communicated to an input of the adder 403 as well as multiplied by coefficient b₁₂ before being communicated to an input of the adder 411. The output of the adder 411 may be communicated to an input of the adder 409. The output of the adder 409 may be communicated to an input of the adder 413 which may correspond to an adder comprised in the second biquad stage 467. The remaining biquad stages, 467, 469, 471 and 473 may be substantially similar to the biquad stage 465. The output of adder 459 in biquad stage 473 may generate the output signal 463.

In operation, the input signal 402 may be summed with the output of the adder 403 at the adder 401. The resulting output signal from the adder 401 may be communicated to the delay cell 405 and multiplied by coefficient b₁₀ before being communicated to the adder 409. The output signal of the delay cell 405 may be communicated to the delay cell 407. The output of the delay cell 407 may be multiplied by coefficient a₁₂ and may be summed with the output of the delay cell 405 that may be multiplied by coefficient a₁₁ at the adder 403. The output of the delay cell 407 may be multiplied by coefficient b₁₂ and may be summed with the output of the delay cell 405 that may be multiplied by coefficient b₁₁ at the adder 411. The output of the adder 411 and the output of the adder 401 that may be multiplied by coefficient b₁₀ may be summed at the adder 409. The output of the adder 409 may then be communicated to the second biquad stage 467. The frequency response of each biquad may be determined utilizing the biquad coefficients, such as those labeled as a₁₁, a₁₂, b₁₁, b₁₂, and b₁₀ in the first biquad stage 465. The overall frequency response of the cascaded biquad compensation filter 400 may be determined by adjusting the biquad coefficients. For example, in a cascaded biquad compensation filter 400 that utilizes five biquad stages, 25 biquad coefficients may need to be adjusted.

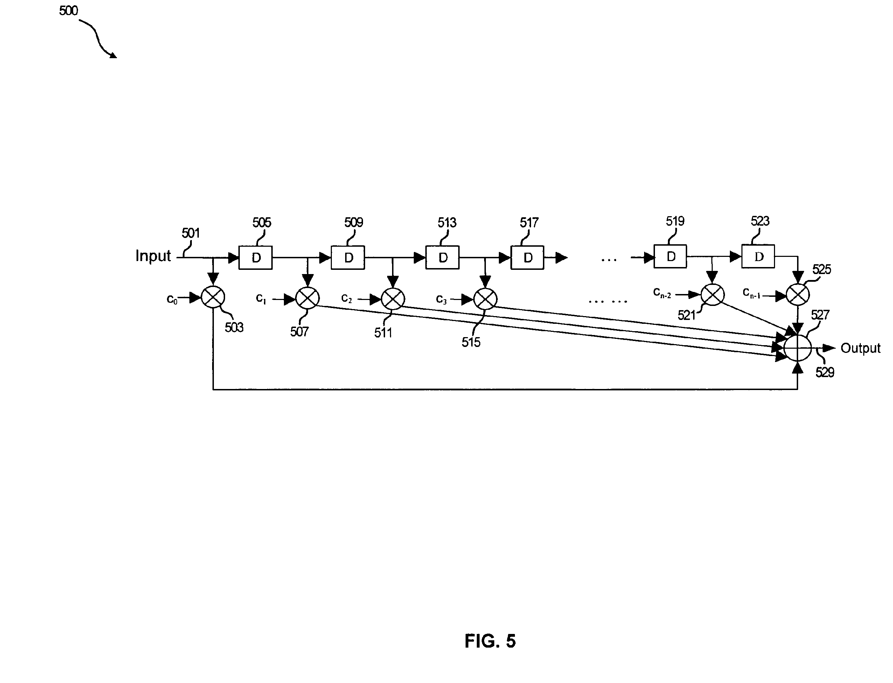

FIG. 5 is a block diagram illustrating an exemplary finite impulse response (FIR) filter, in the direct form in accordance with an embodiment of the invention. Referring to FIG. 5, there is shown an FIR filter 500 that may comprise delay cells 505, 509, 513, 517, 519 and 523, multipliers 503, 507, 511, 515, 521 and 525, and an adder 527. The input signal 501 may be communicated to the multiplier 503 and the delay cell 505. The output of the delay cell 505 may be communicated to the delay cell 509 and also to the multiplier 507. The output of the delay cell 509 may be communicated to the delay cell 513 and to the multiplier 511. This operation may be repeated for a plurality of stages based on the filter design, such as 17, 33, or 65 stages, for example. The output of each multiplier 503, 507, 511, 515, 521 and 525 may be communicated to the adder 527. The output signal generated by the adder 527 may comprise the output signal 529.

In operation, the FIR filter 500 may perform frequency response compensation on an audio input signal 501, which may be utilized to compensate for distortion in the audio signal from output devices such as speakers or ear buds. The input signal 501 may be multiplied by coefficient c₀ at the multiplier 503 and then communicated to the adder 527. The input signal 501 may also be communicated to the delay cell 505. The output of the delay cell 505 may be communicated to the delay cell 509 and also may be multiplied by coefficient c₁ at the multiplier 507 and then communicated to the adder 527. This scheme may be repeated up to the number of stages, n, which may be 17, 33 or 65 for example, such that the output signal 529 may be a sum of the signals from each stage, where each stage may comprise the output of the previous stage through a delay cell, multiplied by a coefficient. The frequency response of the FIR compensation filter 500 may be determined by adjusting coefficients c₀, c₁, c₂, ... cₙ₋₁, where n may be the number of stages in the filter.

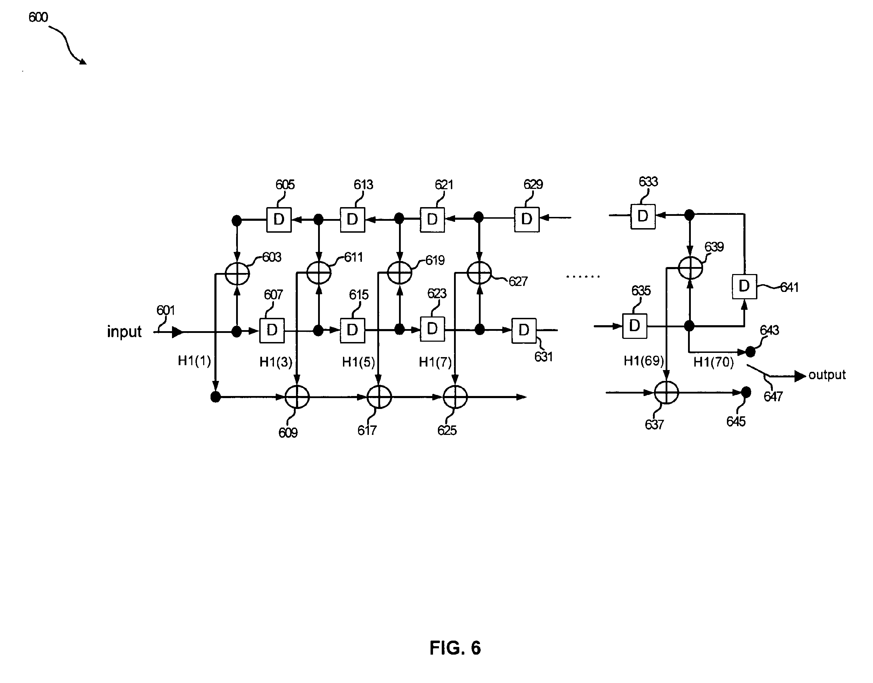

FIG. 6 is a block diagram illustrating an exemplary half-band interpolation filter (HBIF), in accordance with an embodiment of the invention. Referring to FIG. 6 there is shown an HBIF 600 comprising delay cells 605, 607, 613, 615, 621, 623, 629, 631, 633, 635 and 641, adders 603, 609, 611, 617, 619, 625, 627, 637 and 639, and an output switch 647. The input signal 601 may be communicated to the delay cell 607 and the adder 603. The output of delay cell 607 may be communicated to the delay cell 615 and the adder 611. The output of the delay cell 613 may be communicated to the adder 611 and the delay cell 605. The output of the adder 603 may be multiplied by coefficient H1(1) and then communicated to the adder 609. The output of the adder 611 may be multiplied by coefficient H1(3) and then communicated to the adder 609. The output of the delay cell 615 may be communicated to the delay cell 623 and the adder 619. The output of the delay cell 621 may be communicated to the adder 619 and the delay cell 613. The output of the adder 619 may be multiplied by coefficient H1(5) and then communicated to the adder 617 with the output of the adder 609. The output of the delay cell 623 may be communicated to the delay cell 631 and the adder 627. The output of the delay cell 629 may be communicated to the adder 627 and to the delay cell 621. The output of the adder 627 may be multiplied by coefficient H1(7) before being communicated to the adder 625 with the output of adder 617. This scheme may be repeated up to the total number of stages, such as 36 stages, for example.

In operation, HBIF 600 may up-sample input signal 610 by a factor of two. The filter coefficients H1(1), H1(3), H1(5)... H1(70) may be adjusted to determine the frequency response of the HBIF 600. The output switch 647 may switch between the output nodes 643 and 645, generating two output samples per input sample.

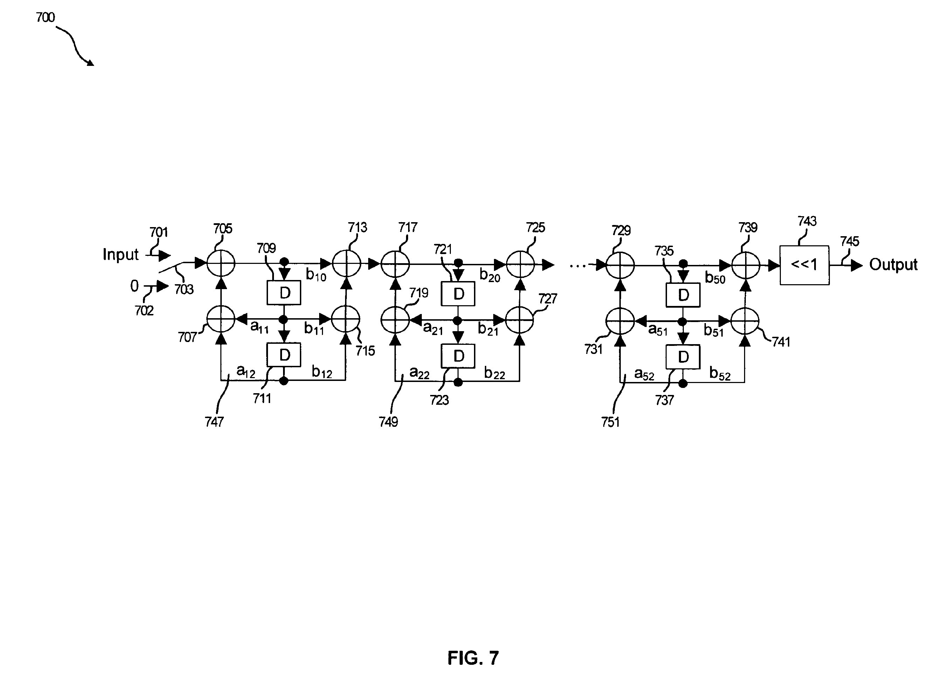

FIG. 7 is a block diagram illustrating an exemplary cascaded biquad infinite impulse response (IIR) interpolation filter, in accordance with an embodiment of the invention. Referring to FIG. 7, there is shown an IIR interpolation filter 700 comprising input switch 703, adders 705, 707, 713, 715, 717, 719, 725, 727, 729, 731, 739 and 741, delay cells 709, 711, 721, 723, 735 and 737, and bit shift block 743. The IIR interpolation filter 700 may comprise a plurality of stages. A first stage may comprise adders 705, 707, 713 and 715, and delay cells 709 and 711.

Regarding the first stage of the IIR interpolation filter 700, the input switch 703 may be communicated to the adder 705. The output of the adder 705 may be communicated to the delay cell 709 and multiplied by coefficient b₁₀ before being communicated to the adder 713. The output of the delay cell 709 may be multiplied by coefficient all and then communicated to the adder 707. The output of the delay cell 709 may be communicated to the delay cell 711 and may also be multiplied by coefficient b₁₁ and then communicated to the adder 715. The output of the delay cell 709 may also be multiplied by coefficient a₁₁ and communicated to the adder 707. The output of the delay cell 711 may be multiplied by coefficient a₁₂ and communicated to the adder 707 and multiplied by coefficient b₁₂ before being communicated to the adder 715. The output of the adder 707 may be communicated to the adder 705, and the output of the adder 715 may be communicated to the adder 713. The output of the adder 713 may be the output of the first stage 747 of the cascaded biquad, which may have five stages, for example. The coefficients a₁₁, a₁₂, b₁₀, b₁₁ and b₁₂ may be utilized to determine the frequency response of the first stage 747. This scheme may be repeated for the subsequent stages of the IIR interpolator 700.

In operation, the cascaded biquad IIR interpolation filter 700 may up-sample the input signal 701 by a factor of two. The input switch 703 may insert zeros between two adjacent input samples by switching between the zero input 702 and the input signal 701. The resulting signal may be filtered by the cascaded biquad IIR filter. In an exemplary embodiment of the invention, the cascaded biquad IIR filter 700 may comprise five stages. Following the fifth stage 751, the output signal from the adder 739 may be bit shifted to provide gain to compensate for gain loss due to the zero insertion by the input switch 703.

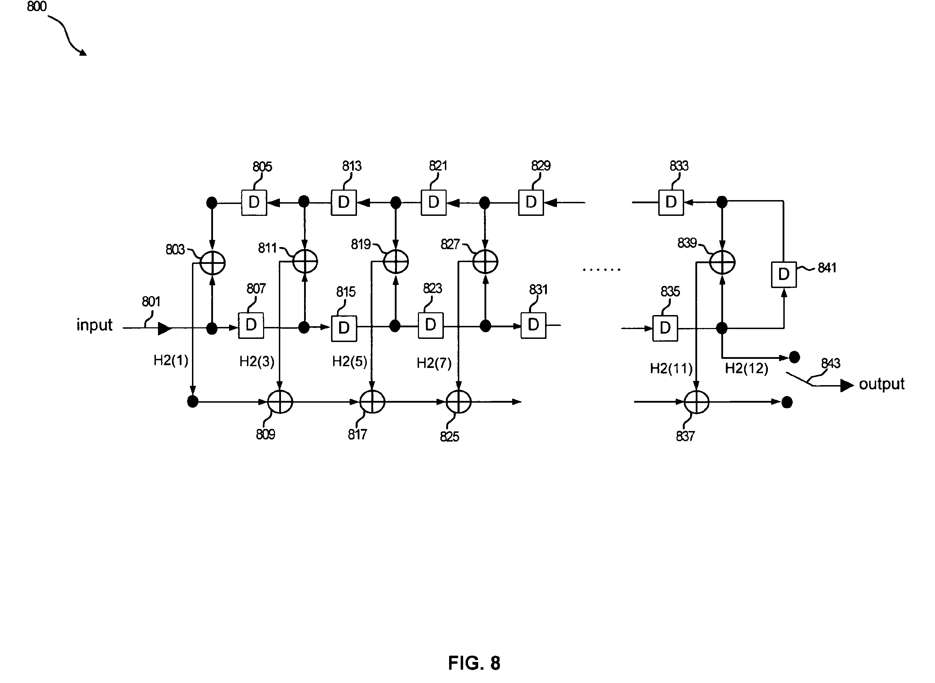

FIGS. 8-11 are block diagrams illustrating exemplary half-band interpolation filters, in accordance with an embodiment of the invention. Referring to FIG. 8, there is shown an HBIF 800 comprising delay cells 805, 807, 813, 815, 821, 823, 829, 831, 833, 835 and 841, adders 803, 809, 811, 817, 819, 825, 827, 837 and 839, and an output switch 843. The scheme of the HBIF 800 may be substantially similar to that described with respect to FIG. 6, but with fewer stages, such as 7 stages. In this regard, the HBIF 800 may up-sample an input signal by a factor of two and the frequency response of the HBIF 800 may be determined by coefficients H2(1), H2(3), H2(5), H2(7), H2(9), H2(11) and H2(12).

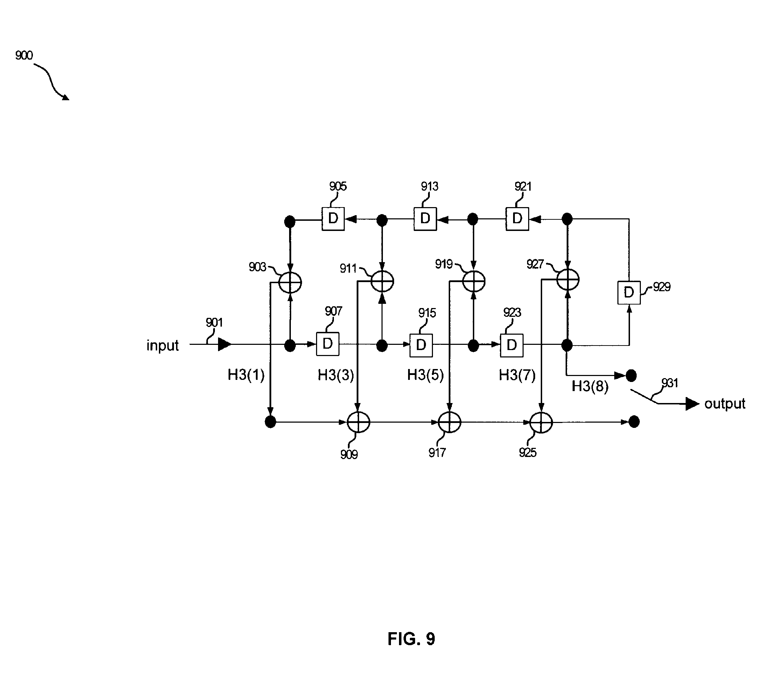

Referring to FIG. 9, there is shown an HBIF 900 comprising delay cells 905, 907, 913, 915, 921, 923 and 929, adders 903, 909, 911, 917, 919, 925 and 927, and output switch 931. The scheme of the HBIF 900 may be essentially similar to that described with respect to FIG. 6, but with fewer stages, such as five stages. In this regard, the HBIF 900 may up-sample an input signal by a factor of two and the frequency response of the HBIF 900 may be determined by coefficients H3(1), H3(3), H3(5), H3(7) and H3(8).

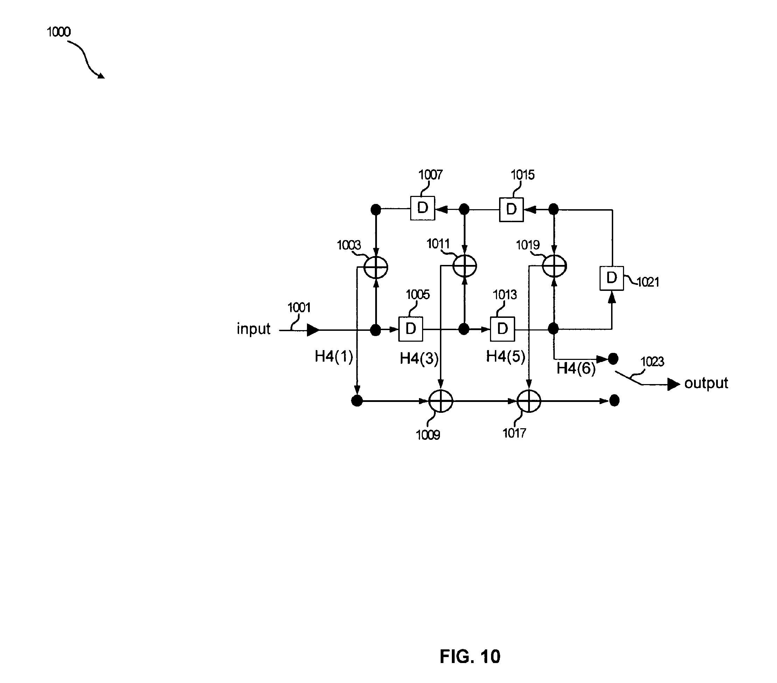

Referring to FIG. 10, there is shown an HBIF 1000 comprising delay cells 1005, 1007, 1013, 1015 and 1021, adders 1003, 1009, 1011, 1017 and 1019, and output switch 1023. The scheme of the HBIF 1000 may be substantially similar to that described with respect to FIG. 6, but with fewer stages, such as four stages. In this regard, the HBIF 1000 may up-sample an input signal by a factor of two and the frequency response of the HBIF 1000 may be determined by coefficients H4(1), H4(3), H4(5) and H4(6).

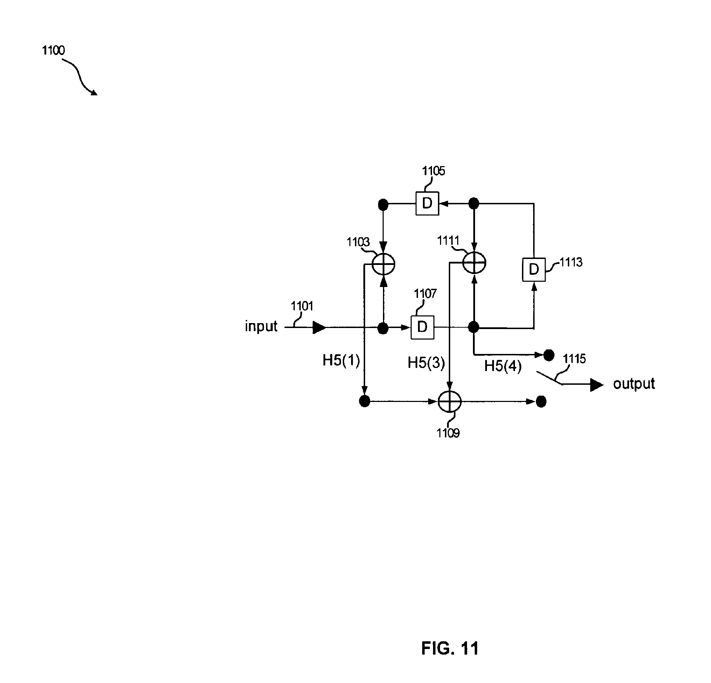

Referring to FIG. 11, there is shown an HBIF 1100 comprising delay cells 1105, 1107 and 1113, adders 1103, 1109 and 1111, and output switch 1115. The scheme may be substantially similar to that described with respect to FIG. 6, but with fewer stages, such as four stages. In this regard, the HBIF 1100 may up-sample an input signal by a factor of two and he frequency response of the HBIF 1100 may be determined by coefficients H5(1), H5(3) and H5(4). Moreover, the HBIF 1100 may be substantially similar to the HBIF4 313 and/or the HBIF5 315 described with respect to FIG. 3. In instances where the HBIF5 315 may be utilized, for audio input sampling rates below 12 kHz, for example, the filter utilized may be as shown in FIG. 11, but with the frequency response determined by coefficients H6(1), H6(3) and H6(4).

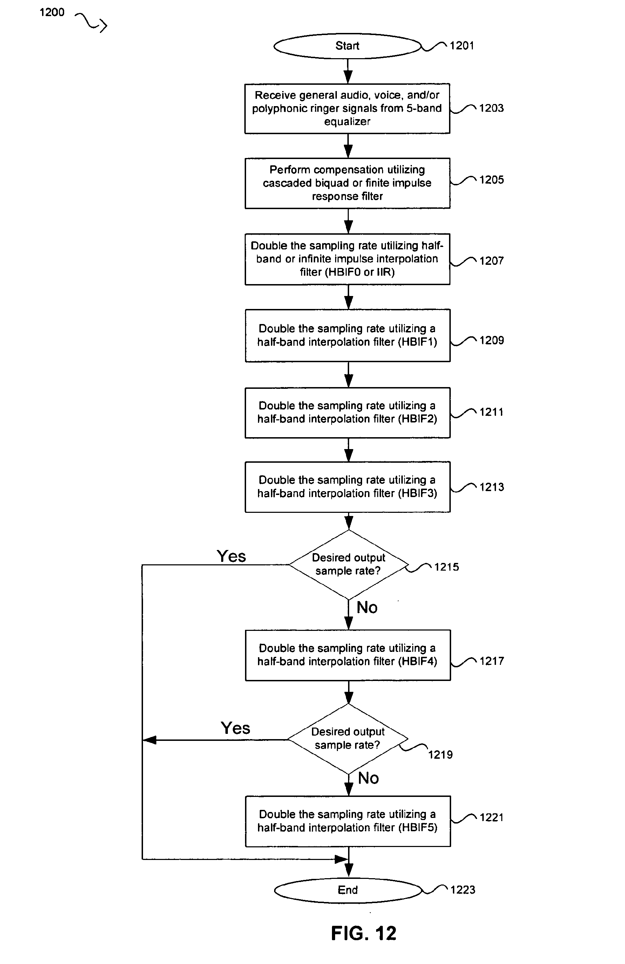

FIG. 12 is a flow diagram illustrating exemplary steps for audio signal compensation and sampling rate interpolation, in accordance with an embodiment of the invention. Referring to FIG. 12, there is shown a flow diagram 1200. After start step 1201, in step 1203, the compensation filter 303 disclosed in FIG. 3 may receive input audio signals from a 5-band equalizer. In step 1205, the compensation filter, which may be a cascade biquad filter or an FIR filter, may compensate the input audio signal. In step 1207, the sample rate of the compensated signal generated by the compensation filter 303 may be doubled by the interpolator block 305, which may be an HBIF or may be an IIR filter. In step 1209, the sample rate of the signal generated by the first interpolator block 305 may be doubled by the second interpolation filter 307, which may be an HBIF, such as HBIF1 307.

In step 1211, the sample rate of the audio signal generated by the second interpolation filter 307 may be doubled by the third interpolation filter 309, which may be an HBIF, such as HBIF2 309. In step 1213, the sample rate of the audio signal generated by the third interpolation filter 309 may be doubled by the fourth interpolation filter 311, which may be an HBIF, such as HBIF3 311. In step 1215, when the resulting sampling rate in step 1213 may be equivalent to a desired output sampling rate, the process may proceed to the end step 1223. However, when the sampling rate may not be equivalent to the desired output sampling rate, the process may proceed to the next step, 1217. In step 1217, the sample rate of the audio signal generated by the fourth interpolation filter 313 may be doubled by the fifth interpolation filter 313, which may be an HBIF, such as HBIF4 313. In step 1219, when the resulting sampling rate may be equivalent to the desired output sampling rate, the process may proceed to the end step 1223. However, when the sampling rate may not be equivalent to the desired output sampling rate, the process may proceed to the next step, 1221. In step 1221, the sample rate of the audio signal generated by the fifth interpolation filter 313 may be doubled by the sixth interpolation filter 315, which may be an HBIF, such as HBIF5 315. After step 1221, the process then may proceed to end step 1223.

Certain embodiments of the invention are described for receiving multi-rate digital audio signals 301. Aspects of the method may comprise up-sampling a number of digital audio signals and converting the up-sampled digital audio signals to a common data rate prior to mixing. The digital audio signals sampling rates may be converted utilizing interpolator block 305 and half-band interpolators 307, 309, 311, 313 and 315. The up-sampling may also utilize an infinite impulse response interpolator 700. A portion of the up-sampled digital audio signals may have a common data rate. The common data rate may be determined by the number of half-band interpolators 307, 309, 311, 313, and 315 utilized. Distortion in the digital audio signals may be compensated by utilizing a number of cascaded biquad filters 465, 467, 469, 471 and 473 or a finite impulse response filter 500.

Certain embodiments of the invention may comprise a machine-readable storage having stored thereon, a computer program having at least one code section for communicating information within a network, the at least one code section being executable by a machine for causing the machine to perform one or more of the steps described herein.

Accordingly, aspects of the invention may be realized in hardware, software, firmware or a combination thereof. The invention may be realized in a centralized fashion in at least one computer system or in a distributed fashion where different elements are spread across several interconnected computer systems. Any kind of computer system or other apparatus adapted for carrying out the methods described herein is suited. A typical combination of hardware, software and firmware may be a general-purpose computer system with a computer program that, when being loaded and executed, controls the computer system such that it carries out the methods described herein.

One embodiment of the present invention may be implemented as a board level product, as a single chip, application specific integrated circuit (ASIC), or with varying levels integrated on a single chip with other portions of the system as separate components. The degree of integration of the system will primarily be determined by speed and cost considerations. Because of the sophisticated nature of modern processors, it is possible to utilize a commercially available processor, which may be implemented external to an ASIC implementation of the present system. Alternatively, if the processor is available as an ASIC core or logic block, then the commercially available processor may be implemented as part of an ASIC device with various functions implemented as firmware.

The present invention may also be embedded in a computer program product, which comprises all the features enabling the implementation of the methods described herein, and which when loaded in a computer system is able to carry out these methods. Computer program in the present context may mean, for example, any expression, in any language, code or notation, of a set of instructions intended to cause a system having an information processing capability to perform a particular function either directly or after either or both of the following: a) conversion to another language, code or notation; b) reproduction in a different material form. However, other meanings of computer program within the understanding of those skilled in the art are also contemplated by the present invention.

While the invention has been described with reference to certain embodiments, it will be understood by those skilled in the art that various changes may be made and equivalents may be substituted without departing from the scope of the present invention. In addition, many modifications may be made to adapt a particular situation or material to the teachings of the present invention without departing from its scope. Therefore, it is intended that the present invention not be limited to the particular embodiments disclosed, but that the present invention will include all embodiments falling within the scope of the appended claims.

## Claims

1. A method for processing audio signals, the method comprising:
receiving a plurality of digital audio signals at a plurality of different data rates; and
up-sampling each of said received plurality of digital audio signals; and
converting said up-sampled received digital audio signals to a common data rate prior to mixing.

2. The method according to claim 1, comprising converting said plurality of sampling rates in said digital audio signals utilizing half-band interpolators.

3. The method according to claim 2, wherein said common data rate is determined by a number of said half-band interpolators.

4. The method according to claim 1, wherein said up-sampling utilizes infinite impulse response interpolators.

5. The method according to claim 1, wherein a portion of said up-sampled received plurality of digital audio signals has a common data rate.

6. A system for processing audio signals, the system comprising:
one or more circuits for receiving a plurality of digital audio signals at a plurality of different data rates; and
said one or more circuits up-sampling each of said received plurality of digital audio signals; and
said one or more circuits converting said up-sampled received digital audio signals to a common data rate prior to mixing.

7. The system according to claim 6, comprising up-converting said plurality of sampling rates in said digital audio signals utilizing half-band interpolators.

8. The system according to claim 7, wherein said common data rate is determined by a number of said half-band interpolators.

9. The system according to claim 6, wherein said up-sampling utilizes infinite impulse response interpolators.

10. A machine-readable storage having stored thereon, a computer program having at least one code section for processing audio signals, the at least one code section being executable by a machine for causing the machine to perform steps comprising:
receiving a plurality of digital audio signals at a plurality of different data rates; and
up-sampling each of said received plurality of digital audio signals; and
converting said up-sampled received digital audio signals to a common data rate prior to mixing.
